# EUROPÄISCHE PATENTSCHRIFT

(11) **EP 2 495 869 B1**
(45) Veröffentlichungstag und Bekanntmachung des Hinweises auf die Patenterteilung: **30.05.2018**
(21) Anmeldenummer: 12154711.1
(22) Anmeldetag: 09.02.2012
(51) Int. Cl.: H02P 29/02, H03K 17/78, G05B 9/02, H03K 17/795

(54) **Steuergerät mit Safe-Torque-Off-Funktion für einen Elektromotor**
Control device with safe-torque-off function for an electric motor
Appareil de commande doté d'une fonction d'arrêt de couple fiable pour un moteur électrique

(30) Priorität: 10.02.2011 DE 102011003922
(43) Veröffentlichungstag der Anmeldung: 05.09.2012
(73) Patentinhaber: Lenze Automation GmbH, 31855 Aerzen (DE)
(72) Erfinder: Tieste, Karl-Dieter, Prof. Dr.-Ing., 38304 Wolfenbüttel (DE)
(74) Vertreter: Patentanwälte Ruff, Wilhelm, Beier, Dauster & Partner mbB

(56) Entgegenhaltungen:
- EP-A2- 1 724 915
- WO-A1-2009/080384
- DE-A1- 19 962 497
- DE-C1- 10 059 173
- US-A1- 2010 327 667

## Beschreibung

Die Erfindung betrifft ein Steuergerät, beispielsweise in Form eines Frequenzumrichters oder eines Servo-Reglers, mit Safe-Torque-Off-Funktion für einen Elektromotor.

Steuergeräte mit Safe-Torque-Off-Funktion überwachen üblicherweise ein erstes und ein zweites Aktuatorsignal an zugehörigen Aktuatorsignal-Anschlüssen. Nur wenn beide Aktuatorsignale den Betriebszustand signalisieren, beispielsweise jeweils einen Pegel von 24 V aufweisen, wird die Erzeugung einer hochfrequenten Betriebsspannung für den Elektromotor freigegeben, d.h. es kann ein Antriebsdrehmoment mittels des Elektromotors erzeugt werden.

Die DE 199 62 497 A1 zeigt eine Schaltungsanordnung zum sicheren Abschalten einer Anlage mit einem Meldegerät, das in Abhängigkeit von einem Betriebszustand der Anlage ein definiertes Ausgangssignal erzeugt, und mit einem Sicherheitsschaltgerät, das in Abhängigkeit von dem definierten Ausgangssignal die Anlage fehlersicher abschaltet.

Die WO 2009/080384 A1 zeigt eine Sicherheitsanordnung, bei der ein Schütz zur Anschaltung einer Steuerspannung an ein Betätigungselement eines Hauptschalters vorgesehen ist.

Die US 2010/0327667 A1 zeigt eine Sicherheitsvorrichtung mit einer Steuereinheit, die ein Steuersignal zum Steuern einer zu überwachenden Vorrichtung erzeugt, und einer Sicherheitsfunktionseinheit, die mit der Steuereinheit verbunden ist und die eine vorbestimmte Sicherheitsfunktion ausführt.

Die EP 1 724 915 A2 zeigt einen unabhängigen Sicherheitsprozessor zur Deaktivierung des Betriebs von Geräten mit hoher Leistung.

Die DE 100 59 173 C1 zeigt eine Antriebssteuerung für einen Drehstrommotor über einen Wechselrichter in sicherer Technik.

Der Erfindung liegt die Aufgabe zugrunde, ein Steuergerät mit Safe-Torque-Off-Funktion zur Verfügung zu stellen, das eine hohe Betriebssicherheit aufweist und gleichzeitig eine kostengünstig Realisierung der Safe-Torque-Off-Funktion ermöglicht.

Die Erfindung löst diese Aufgabe durch ein Steuergerät nach Anspruch 1. Bevorzugte Ausführungsformen sind Gegenstand der Unteransprüche, die hiermit durch Bezugnahme zum Inhalt der Beschreibung gemacht werden.

Das Steuergerät, insbesondere in Form eines Frequenzumrichters oder eines Servo-Reglers, mit Safe-Torque-Off-Funktion für einen Elektromotor umfasst einen ersten Aktuatorsignal-Anschluss, der mit einem ersten Aktuatorsignal beaufschlagbar ist, und einen zweiten Aktuatorsignal-Anschluss, der mit einem zweiten Aktuatorsignal beaufschlagbar ist, Leistungshalbleiter, beispielsweise IGBTs, MOSFET oder BipolarTransistoren, zur Erzeugung einer hochfrequenten Betriebsspannung für den Elektromotor, beispielsweise mit einer Grundfrequenz von ca. 50 Hz und einer Schaltfrequenz in einem Bereich von 1 kHz bis 40 kHz, erste Übertragungsmittel oder Treiber, beispielsweise in Form von so genannten High-Side-Treibern, Gattern, Optokopplern, etc., die ein jeweiliges Ausgangssignal in Abhängigkeit von einem Eingangssignal nur dann erzeugen, wenn eine zugehörige Versorgungsspannung zur Verfügung gestellt ist bzw. anliegt, wobei ein jeweiliger Leistungshalbleiter mit einem zugehörigen Ausgangssignal der ersten Übertragungsmittel bzw. Treiber angesteuert ist, und eine Versorgungsspannung-Erzeugungseinheit, die die Versorgungsspannung für die ersten Übertragungsmittel in Abhängigkeit von dem ersten und dem zweiten Aktuatorsignal nur dann erzeugt, wenn das erste und das zweite Aktuatorsignal jeweils den Betriebszustand signalisieren, beispielsweise einen Pegel von 24 V DC aufweisen, so dass die Leistungshalbleiter nur im Betriebszustand die hochfrequente Betriebsspannung für den Elektromotor erzeugen können. Der Betriebszustand ist ein Zustand, während dem die hochfrequente Betriebsspannung für den Elektromotor vorhanden ist, d.h. ein Motordrehmoment erzeugt werden darf. Wenn ein Aktuatorsignal oder beide Aktuatorsignale einen Zustand anzeigen, der sich vom Betriebszustand unterscheidet, beispielsweise wenn eines der Aktuatorsignale oder beide Aktuatorsignale spannungslos sind, wird die Erzeugung der hochfrequenten Betriebsspannung für den Elektromotor verhindert, da keine Versorgungsspannung für die ersten Übertragungsmittel erzeugt wird, wodurch diese keine Ausgangssignale bzw. nur Ausgangssignale mit konstantem Pegel erzeugen.

Die Versorgungsspannung-Erzeugungseinheit umfasst einen Schwingkreis, der nur dann ein Schwingungssignal an einem Schwingungssignalausgang erzeugt, wenn eine Schwingkreisversorgungsspannung vorhanden ist, wobei die Schwingkreisversorgungsspannung nur dann vorhanden bzw. erzeugt wird, wenn das zweite Aktuatorsignal den Betriebszustand anzeigt, ein zweites, insbesondere galvanisch trennendes, Übertragungsmittel, das eingangsseitig zwischen den ersten Aktuatorsignal-Anschluss und den Schwingungssignalausgang eingeschleift ist, eine Verstärkerschaltung, die ein Signal am Ausgang des zweiten Übertragungsmittels verstärkt und als verstärktes Signal ausgibt, eine Entkopplungsschaltung, die das verstärkte Signal filtert, indem ein Gleichanteil aus dem verstärkten Signal entfernt wird, und das gefilterte Signal ausgibt, und einen Gleichrichter, der aus dem gefilterten Signal die Versorgungsspannung für die ersten Übertragungsmittel erzeugt.

In einer Weiterbildung ist eine Schwingkreisversorgungsspannung-Erzeugungseinheit vorgesehen, die die Schwingkreisversorgungsspannung in Abhängigkeit von dem zweiten Aktuatorsignal erzeugt, wobei die Schwingkreisversorgungsspannung nur dann mit einem von Null verschiedenen Wert erzeugt wird, wenn das zweite Aktuatorsignal den Betriebszustand signalisiert.

In einer Weiterbildung weist die Verstärkerschaltung eine Spannungsverstärkung von kleiner als Eins auf, wodurch sichergestellt werden kann, dass der Verstärker nicht selbstständig, d.h. ohne Anregung durch das Signal am Ausgang des zweiten Übertragungsmittels, schwingen kann.

In einer Weiterbildung umfasst die Verstärkerschaltung zwei als Gegentaktpaar geschaltete Transistoren in Emitterfolgerschaltung.

In einer Weiterbildung umfasst die Entkopplungsschaltung zwei in Reihe geschaltete Kondensatoren, die zwischen den Eingang und den Ausgang der Entkopplungsschaltung eingeschleift sind und die für die DC-Entkopplung sorgen.

In einer Weiterbildung ist der Schwingkreis als Schmitt-Trigger-Oszillator ausgebildet.

In einer Weiterbildung sind die ersten Übertragungsmittel Optokoppler.

In einer Weiterbildung ist das zweite Übertragungsmittel ein Optokoppler.

Die Erfindung wird nachfolgend unter Bezugnahme auf die Zeichnungen beschrieben, die bevorzugte Ausführungsformen der Erfindung darstellen. Hierbei zeigt schematisch:
- Fig. 1: eine Versorgungsspannung-Erzeugungseinheit eines Frequenzumrichters, die eine Versorgungsspannung für Übertragungsmittel bzw. Treiber eines Leistungsteils des Frequenzumrichters erzeugt, und
- Fig. 2: einen Ausschnitt aus einem Leistungsteil des Frequenzumrichters mit einem exemplarischen Übertragungsmittel, das mit der Versorgungsspannung beaufschlagt ist, die mittels der Versorgungsspannung-Erzeugungseinheit aus Fig. 1 erzeugt wird.

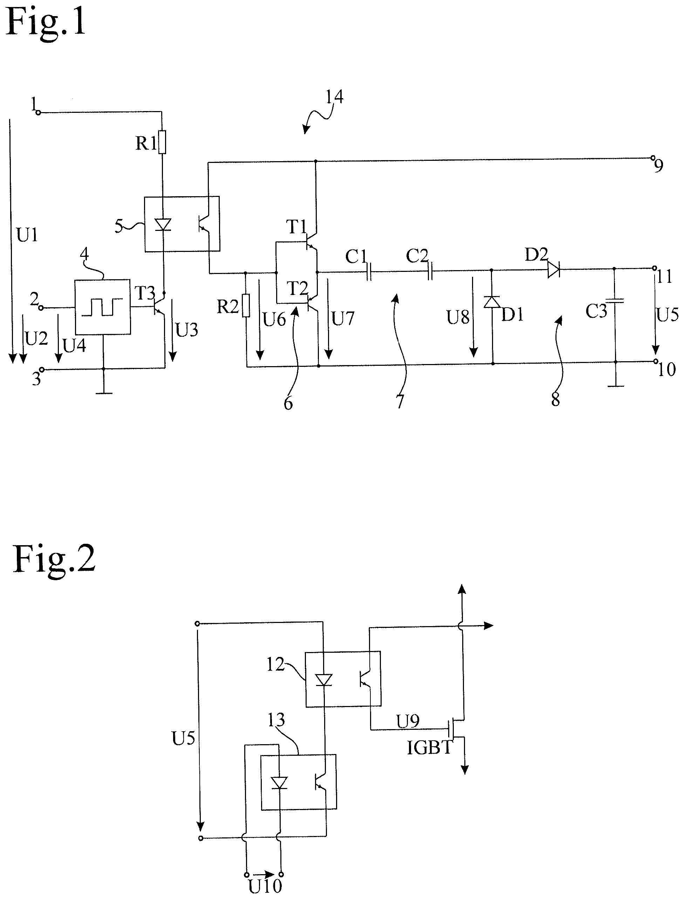

Fig. 1 zeigt eine Versorgungsspannung-Erzeugungseinheit 14 als Teil eines nicht näher dargestellten Frequenzumrichters. Bis auf die Versorgungsspannung-Erzeugungseinheit 14 entspricht der Frequenzumrichter einem herkömmlichen Frequenzumrichter, so dass auf eine ausführliche Beschreibung der für die Erfindung nicht wesentlichen Funktionen des Frequenzumrichters verzichtet werden kann.

Die Versorgungsspannung-Erzeugungseinheit 14 erzeugt betriebszustandsabhängig eine Versorgungsspannung U5 für Übertragungsmittel bzw. Treiber eines Leistungsteils des Frequenzumrichters, wobei ein derartiges Übertragungsmittel bzw. ein derartiger Treiber exemplarisch in Fig. 2 als ein einzelner Optokoppler 12 dargestellt ist, der zur Ansteuerung eines Leistungshalbleiters in Form eines IGBTs dient. Es versteht sich, dass weitere, nicht gezeigte Übertragungsmittel bzw. Treiber und zugehörige Leistungshalbleiter im Leistungsteil vorgesehen sind, die in herkömmlicher Art und Weise zur Erzeugung einer hochfrequenten Betriebsspannung für den Elektromotor dienen. Anstatt des gezeigten Optokopplers 12 sind selbstverständlich auch High-Side-Treiber, Gatter etc. verwendbar. Anstatt des IGBTs können auch MOSFET- oder BipolarTransistoren oder andere geeignete Typen von Leistungshalbleitern verwendet werden.

Wesentlich ist, dass die Übertragungsmittel bzw. Treiber ein Ausgangssignal für ihren zugehörigen Leistungshalbleiter in Abhängigkeit von ihrem Eingangssignal, in Fig. 2 in Form eines Stroms durch die Sende-LED des Optokopplers 12, nur dann erzeugen, wenn die Versorgungsspannung U5 zur Verfügung gestellt wird, so dass durch Abschalten der Versorgungsspannung U5 ein Safe-Torque-Off-Zustand bewirkt werden kann.

Ein herkömmliches PWM-Signal U10 wird von einer herkömmlichen Steuereinheit des Frequenzumrichters erzeugt und mittels eines Optokopplers 13 übertragen. Wenn die Versorgungsspannung U5 mit geeignetem Pegel erzeugt wird, entspricht das Ausgangssignal U9 des Optokopplers 12 in seinem zeitlichen Verlauf dem PWM-Signal U10.

Die Versorgungsspannung-Erzeugungseinheit 14 weist einen ersten Aktuatorsignal-Anschluss 1, der mit einem ersten Aktuatorsignal U1 beaufschlagbar ist, einen zweiten Aktuatorsignal-Anschluss 2, der mit einem zweiten Aktuatorsignal U2 beaufschlagbar ist, und einen Masse-Anschluss 3 auf.

Die Aktuatorsignale U1 und U2 können Output Signal Switching Device (OSSD)-Signale sein, bei denen ein Betriebszustand durch ein High-Signal mit einem Pegel in einem Spannungsbereich von ca. 15V bis 30V signalisiert wird, wobei ein High-Signal durch kurze Testimpulse mit einer Dauer von weniger als 1 ms unterbrochen ist. Alternativ können die Aktuatorsignale U1 und U2 auch reine Gleichspannungssignale sein.

Zur Signalisierung eines Fehlerzustands bzw. eines Zustands, bei dem die Erzeugung der hochfrequenten Betriebsspannung zu verhindern ist, wird mindestens eines der Aktuatorsignale U1 und U2 dauerhaft mit einem Low- oder Massepegel erzeugt bzw. der entsprechende Aktuatorsignal-Anschluss 1 und/oder 2 wird floatend geschaltet, indem beispielsweise ein Sicherheitskontakt, der im Betriebszustand die Aktuatorsignal-Anschlüsse 1 und 2 mit 24 V DC verbindet, geöffnet wird, beispielsweise weil eine Person eine Sicherheitslichtschranke unterbricht.

Die Versorgungsspannung-Erzeugungseinheit 14 umfasst weiter einen Schwingkreis 4, beispielsweise in Form eines Schmitt-Trigger-Oszillators, der nur dann ein Schwingungssignal U3 an einem Schwingungssignalausgang, hier an einem Kollektor eines als Verstärker dienenden Transistors T3, erzeugt, wenn eine Schwingkreisversorgungsspannung U4 vorhanden ist. Die Schwingkreisversorgungsspannung U4 ist in der gezeigten Ausführungsform identisch mit dem zweiten Aktuatorsignal U2, d.h. das Schwingungssignal U3 wird nur dann erzeugt, wenn das zweite Aktuatorsignal U2 den Betriebszustand signalisiert, d.h. einen entsprechenden High-Pegel bzw. High-Zustand aufweist.

Zusätzlich kann eine Schwingkreisversorgungsspannung-Erzeugungseinheit vorgesehen sein, die die Schwingkreisversorgungsspannung U4 mit geeignetem Pegel, beispielsweise 5V, in Abhängigkeit von dem zweiten Aktuatorsignal U2 erzeugt, wobei die Schwingkreisversorgungsspannung U4 nur dann mit einem von Null verschiedenen Pegel erzeugt wird, wenn das zweite Aktuatorsignal U2 den Betriebszustand signalisiert.

Die Versorgungsspannung-Erzeugungseinheit 14 umfasst weiter ein galvanisch trennendes Übertragungsmittel in Form eines Optokopplers 5, der eingangsseitig, d.h. mit seiner Sende-LED, zwischen den ersten Aktuatorsignal-Anschluss 1 und den Schwingungssignalausgang eingeschleift ist. Ausgangsseitig ist die Kollektor-Emitter-Strecke des Optokopplers 5 in Serie mit einem Widerstand R2 zwischen einen Spannungsversorgungsanschluss 9 des Leistungsteils und einen Bezugspotentialanschluss 10 des Leistungsteils eingeschleift. Das Bezugspotential des Leistungsteils an der Ausgangsseite des Optokopplers 5 und das Bezugspotential auf der Ansteuerseite des Optokopplers 5 können galvanisch verbunden oder galvanisch getrennt sein.

Ein Signal U6 am Ausgang des Optokopplers 5 ist nur dann ein Schwingungssignal, d.h. es weist signifikante AC-Anteile auf, wenn sowohl das erste als auch das zweite Aktuatorsignal U1 und U2 den Betriebszustand signalisieren, da die Sende-LED des Optokopplers nur dann mit Spannung versorgt ist und nur dann auch das Schwingungssignal U3 erzeugt wird, wodurch insgesamt an der Sende-LED eine veränderliche Spannung, beispielsweise eine Rechteckspannung, bewirkt wird, die mittels des Optokopplers 5 übertragen wird.

Das Signal U6 am Ausgang des Optokopplers 5 wird mittels einer Verstärkerschaltung 6 verstärkt und als verstärktes Signal U7 ausgegeben. Die Verstärkerschaltung 6 ist aus zwei als Gegentaktpaar geschalteten Transistoren T1 und T2 in Emitterfolgerschaltung gebildet und weist eine Spannungsverstärkung von kleiner als Eins auf, so dass der Verstärker 6 nicht selbstständig schwingen kann, da das Nyquist-Kriterium für geschlossene Regelkreise bei einer Verstärkung von kleiner als eins nicht erfüllbar ist.

Eine Entkopplungsschaltung 7 der Versorgungsspannung-Erzeugungseinheit 14 in Form von zwei Kondensatoren C1 und C2, die in Reihe zwischen den Eingang und den Ausgang der Entkopplungsschaltung 7 eingeschleift sind, gibt ein gefiltertes Signal U8 aus, das durch Entfernen eines Gleichanteils aus dem verstärkten Signal U7 erzeugt ist.

Ein Gleichrichter 8 mit Dioden D1 und D2 und einem Glättungskondensator C3 erzeugt schließlich aus dem gefilterten Signal U8 die Versorgungsspannung U5 an einem Anschluss 11.

Die Versorgungsspannung U5 wird nur dann mit einem von Null verschiedenen Pegel erzeugt, wenn sowohl das erste als auch das zweite Aktuatorsignal U1 und U2 den Betriebszustand signalisieren, d.h. das Signal U6 am Ausgang des Optokopplers 5 ein Schwingungssignal ist.

Für den Fall, dass das Signal U6 ausschließlich Gleichspannungsanteile umfasst, beträgt der Pegel der Spannung U8 am Ausgang der Entkopplungsschaltung 7 Null Volt, so dass auch die Spannung U5 am Ausgang 11 des Gleichrichters 8 Null Volt beträgt. Mittels des Optokopplers 12 aus Fig. 2 kann daher keine hochfrequente Betriebsspannung für den Elektromotor erzeugt werden, d.h. es stellt sich der Safe-Torque-Off-Zustand ein.

Die Ausgangsspannung U6 des Optokopplers 5 wird unter Verwendung fehlerausschlusstauglicher Bauteile verstärkt.

Es versteht sich, dass anstelle des Optokopplers 5 auch andere, geeignete Übertragungsmittel verwendet werden können.

Die gezeigten Ausführungsformen stellen eine Safe-Torque-Off-Funktion zur Verfügung, die eine hohe Betriebssicherheit gewährleistet und gleichzeitig kostengünstig realisierbar ist.

## Patentansprüche

1. Steuergerät, insbesondere in Form eines Frequenzumrichters oder eines Servo-Reglers, mit Safe-Torque-Off-Funktion für einen Elektromotor, wobei das Steuergerät aufweist:
- einen ersten Aktuatorsignal-Anschluss (1), der mit einem ersten Aktuatorsignal (U1) beaufschlagbar ist, und
- einen zweiten Aktuatorsignal-Anschluss (2), der mit einem zweiten Aktuatorsignal (U2) beaufschlagbar ist,
wobei das Steuergerät **gekennzeichnet ist durch**:
- Leistungshalbleiter (IGBT) zur Erzeugung einer hochfrequenten Betriebsspannung für den Elektromotor,
- erste Übertragungsmittel (12), die ein jeweiliges Ausgangssignal (U9) in Abhängigkeit von einem Eingangssignal nur dann erzeugen, wenn eine zugehörige Versorgungsspannung (U5) zur Verfügung gestellt ist, wobei ein jeweiliger Leistungshalbleiter (IGBT) mit einem zugehörigen Ausgangssignal (U9) angesteuert ist, und
- eine Versorgungsspannung-Erzeugungseinheit (14), die die Versorgungsspannung (U5) für die ersten Übertragungsmittel (12) in Abhängigkeit von dem ersten und dem zweiten Aktuatorsignal (U1, U2) nur dann erzeugt, wenn das erste und das zweite Aktuatorsignal (U1, U2) jeweils einen Betriebszustand signalisieren, so dass die Leistungshalbleiter (IGBT) nur im Betriebszustand die hochfrequente Betriebsspannung für den Elektromotor erzeugen können, wobei die Versorgungsspannung-Erzeugungseinheit (14) umfasst:
- einen Schwingkreis (4), der nur dann ein Schwingungssignal (U3) an einem Schwingungssignalausgang erzeugt, wenn eine Schwingkreisversorgungsspannung (U4) vorhanden ist, wobei die Schwingkreisversorgungsspannung (U4) nur dann vorhanden ist, wenn das zweite Aktuatorsignal (U2) den Betriebszustand anzeigt,
- ein zweites, insbesondere galvanisch trennendes, Übertragungsmittel (5), das eingangsseitig zwischen den ersten Aktuatorsignal-Anschluss (1) und den Schwingungssignalausgang eingeschleift ist,
- eine Verstärkerschaltung (6), die ein Signal (U6) am Ausgang des zweiten Übertragungsmittels (5) verstärkt und als verstärktes Signal (U7) ausgibt,
- eine Entkopplungsschaltung (7), die das verstärkte Signal (U7) filtert, indem ein Gleichanteil aus dem verstärkten Signal (U7) entfernt wird, und das gefilterte Signal (U8) ausgibt, und
- einen Gleichrichter (8), der aus dem gefilterten Signal (U8) die Versorgungsspannung (U5) für die ersten Übertragungsmittel (12) erzeugt.

2. Steuergerät nach Anspruch 1, **gekennzeichnet durch** eine Schwingkreisversorgungsspannung-Erzeugungseinheit, die die Schwingkreisversorgungsspannung (U4) in Abhängigkeit von dem zweiten Aktuatorsignal (U2) erzeugt, wobei die Schwingkreisversorgungsspannung (U4) nur dann mit einem von Null verschiedenen Wert erzeugt wird, wenn das zweite Aktuatorsignal (U2) den Betriebszustand signalisiert.

3. Steuergerät nach Anspruch 1 oder 2, **dadurch gekennzeichnet, dass** die Verstärkerschaltung (6) eine Spannungsverstärkung von kleiner als Eins aufweist.

4. Steuergerät nach einem der vorhergehenden Ansprüche, **dadurch gekennzeichnet, dass** die Verstärkerschaltung (6) zwei als Gegentaktpaar geschaltete Transistoren (T1, T2) in Emitterfolgerschaltung umfasst.

5. Steuergerät nach einem der vorhergehenden Ansprüche, **dadurch gekennzeichnet, dass** die Entkopplungsschaltung (7) zwei in Reihe geschaltete Kondensatoren (C1, C2) umfasst, die zwischen den Eingang und den Ausgang der Entkopplungsschaltung (7) eingeschleift sind.

6. Steuergerät nach einem der vorhergehenden Ansprüche, **dadurch gekennzeichnet, dass** der Schwingkreis (4) als Schmitt-Trigger-Oszillator ausgebildet ist.

7. Steuergerät nach einem der vorhergehenden Ansprüche, **dadurch gekennzeichnet, dass** die ersten Übertragungsmittel Optokoppler (12) sind.

8. Steuergerät nach einem der vorhergehenden Ansprüche, **dadurch gekennzeichnet, dass** das zweite Übertragungsmittel ein Optokoppler (13) ist.

## Claims

1. Control device, in particular in the form of a frequency converter or a servo regulator, with a safe-torque-off function for an electric motor, the control device comprising:
- a first actuator signal terminal (1) to which a first actuator signal (U1) can be applied, and
- a second actuator signal terminal (2) to which a second actuator signal (U2) can be applied,
wherein the control device is **characterized by**:
- a power semiconductor (insulated-gate bipolar transistor, IGBT) for generating a high-frequency operating voltage for the electric motor,
- first transmission means (12) to generate a respective output signal (U9) in response to an input signal only if an associated supply voltage (U5) is provided, wherein a respective power semiconductor (IGBT) is controlled by an associated output signal (U9), and
- a supply voltage generator unit (14) to generate the supply voltage (U5) for the first transmission means (12) in response to the first and the second actuator signals (U1, U2) only if the first and the second actuator signals (U1, U2) each signal an operating condition, so that the power semiconductors (IGBT) are allowed to generate the high-frequency operating voltage for the electric motor only in the operating condition, the supply voltage generator unit (14) comprising:
- an oscillating circuit (4) to generate an oscillating signal (U3) at an oscillating signal output only if an oscillating circuit supply voltage (U4) is present, wherein the oscillating circuit supply voltage (U4) is present only if the second actuator signal (U2) indicates the operating condition,
- a second, in particular electrically isolating, transmission means (5) which is connected on the input side between the first actuator signal terminal (1) and the oscillating signal output,
- an amplifier circuit (6) to amplify a signal (U6) on the output of the second transmission means (5) and to output an amplified signal (U7),
- a decoupling circuit (7) to filter the amplified signal (U7) in that a constant component is removed from the amplified signal (U7) and to output the filtered signal (U8), and
- a rectifier (8) to generate the supply voltage (U5) for the first transmission means (12) from the filtered signal (U8).

2. Control device according to claim 1, **characterized by** an oscillating circuit supply voltage generator unit to generate the oscillating circuit supply voltage (U4) in response to the second actuator signal (U2), wherein the oscillating circuit supply voltage (U4) is generated with a non-zero value only if the second actuator signal (U2) signals the operating condition.

3. Control device according to claim 1 or 2, **characterized in that** the amplifier circuit (6) has a voltage amplification of less than one.

4. Control device according to any of the preceding claims, **characterized in that** the amplifier circuit (6) includes two transistors (T1, T2) connected in a push-pull mode in an emitter follower circuit.

5. Control device according to any of the preceding claims, **characterized in that** the decoupling circuit (7) includes two capacitors (C1, C2) connected in series, which are connected between the input and the output of the decoupling circuit (7).

6. Control device according to any of the preceding claims, **characterized in that** the oscillating circuit (4) is a Schmitt trigger oscillator.

7. Control device according to any of the preceding claims, **characterized in that** the first transmission means are optical couplers (12).

8. Control device according to any of the preceding claims, **characterized in that** the second transmission means is an optical coupler (13).

## Revendications

1. Appareil de commande, en particulier sous la forme d'un convertisseur de fréquence ou d'un servorégulateur, ayant une fonction d'arrêt sécurisé du couple pour un moteur électrique, dans lequel le dispositif de commande comprend :
- un premier raccordement de signal d'actionneur (1) auquel peut être appliqué un premier signal d'actionneur (U1), et
- un deuxième raccordement de signal d'actionneur (2) auquel peut être appliqué un deuxième signal d'actionneur (U2),
dans lequel l'appareil de commande est **caractérisé par** :
- des semi-conducteurs de puissance (IGBT) destinés à générer une tension de fonctionnement à haute fréquence pour le moteur électrique,
- des premiers moyens de transmission (12) qui ne génèrent un signal de sortie respectif (U9) en fonction d'un signal d'entrée que si une tension d'alimentation associée (U5) est délivrée, dans lequel un semi-conducteur de puissance (IGBT) respectif est commandé par un signal de sortie associé (U9), et
- une unité génératrice de tension d'alimentation (14), qui ne génère la tension d'alimentation (U5) pour le premier moyen de transmission (12) en fonction des premier et deuxième signaux d'actionneur (U1, U2) que lorsque les premier et deuxième signaux d'actionneur (U1, U2) signalent respectivement un état de fonctionnement, de manière à ce que les semi-conducteurs de puissance (IGBT) ne puissent générer la tension de fonctionnement à haute fréquence pour le moteur électrique que dans l'état de fonctionnement, dans lequel l'unité génératrice de tension d'alimentation (14) comprend :
- un circuit oscillant (4) qui ne génère un signal oscillant (U3) à une sortie de signal oscillant que lorsqu'une tension d'alimentation de circuit oscillant (U4) est présente, dans lequel la tension d'alimentation de circuit oscillant (U4) n'est présente que lorsque le deuxième signal d'actionneur (U2) indique l'état de fonctionnement,
- un deuxième moyen de transmission (5), en particulier à séparation galvanique, qui est intercalé côté entrée entre le premier raccordement de signal d'actionneur (1) et la sortie de signal oscillant,
- un circuit amplificateur (6) qui amplifie un signal (U6) à la sortie du deuxième moyen de transmission (5) et le délivre en tant que signal amplifié (U7),
- un circuit de découplage (7) qui filtre le signal amplifié (U7) en éliminant une composante continue du signal amplifié (U7) et qui délivre le signal filtré (U8), et
- un redresseur (8) qui génère la tension d'alimentation (U5) pour les premiers moyens de transmission (12) à partir du signal filtré (U8).

2. Appareil de commande selon la revendication 1, **caractérisé par** une unité génératrice de tension d'alimentation de circuit oscillant qui génère la tension d'alimentation de circuit oscillant (U4) en fonction du deuxième signal d'actionneur (U2), dans lequel la tension d'alimentation de circuit oscillant (U4) n'est générée avec une valeur différente de zéro que lorsque le deuxième signal d'actionneur (U2) signale l'état de fonctionnement.

3. Appareil de commande selon la revendication 1 ou 2, **caractérisé en ce que** le circuit amplificateur (6) présente un gain de tension inférieur à 1.

4. Appareil de commande selon l'une des revendications précédentes, **caractérisé en ce que** le circuit amplificateur (6) comprend deux transistors (T1, T2) connectés sous la forme d'une paire push-pull dans un circuit émetteur-suiveur.

5. Appareil de commande selon l'une des revendications précédentes, **caractérisé en ce que** le circuit de découplage (7) comprend deux condensateurs (C1, C2) connectés en série et intercalés entre l'entrée et la sortie du circuit de découplage (7).

6. Appareil de commande selon l'une des revendications précédentes, **caractérisé en ce que** le circuit oscillant (4) est réalisé sous la forme d'un oscillateur-déclencheur de Schmitt.

7. Appareil de commande selon l'une des revendications précédentes, **caractérisé en ce que** les premiers moyens de transmission sont des optocoupleurs (12) .

8. Appareil de commande selon l'une des revendications précédentes, **caractérisé en ce que** le deuxième moyen de transmission est un optocoupleur (13) .
